# EUROPEAN PATENT APPLICATION

(11) **EP 4 693 397 A1**
(43) Date of publication of application: **11.02.2026**
(21) Application number: 24781003.9
(22) Date of filing: 02.02.2024
(51) Int. Cl.: H01L 23/367, H01L 23/40, H02J 7/00, B60L 53/22, H05K 7/20

(54) **FIXING ASSEMBLY AND SWITCHING ELEMENT COMPRISING SAME**

(30) Priority: 29.03.2023 KR 20230041549; 16.01.2024 KR 20240007025
(71) Applicant: LG INNOTEK CO. LTD, Gangseo-gu Seoul 07796 (KR)
(72) Inventor: LEE, Mi Sun, Seoul 07796 (KR); YOON, Dong Keun, Seoul 07796 (KR); JEON, Ji Hwan, Seoul 07796 (KR)
(74) Representative: Plasseraud IP
(86) International application number: PCT/KR2024/001621
(87) International publication number: WO 2024/205008

(57) **Abstract**

A fixing assembly according to an embodiment of the present invention comprises: a heat dissipation member including, on one surface thereof, a base on which a switching element is disposed, and on the other surface thereof, a plurality of heat dissipation fins protruding from the base; and a fixing member that is inserted from one side to the other side of the heat dissipation member to fix the switching element and the heat dissipation member to each other, wherein the fixing member has a clip shape that presses the switching element toward the heat dissipation member.

## Description

### [Technical Field]

The present invention relates to a fixing assembly and a switching element including the same.

### [Background Art]

Various electronic components constituting electronic products are mounted on a printed circuit board on which circuit patterns are printed. Such electronic components are provided with switching elements for applying power to other electronic components. And the switching element is fixed by a fixing assembly.

The switching element must be stably fixed to the substrate for signal transmission and electrical connection. In addition, a switching element is an electronic component that generates heat and needs to be fixed by a structure with high heat dissipation efficiency.

### [Detailed Description of the Invention]

### [Technical Subject]

The technical problem to be solved by the present invention is to provide a fixing assembly and a switching element including the same.

### [Technical Solution]

In order to solve the above technical problem, the fixing assembly according to the embodiment of the present invention comprises: a heat dissipation member including, on one surface thereof, a base on which a switching element is disposed, and on the other surface thereof, a plurality of heat dissipation fins being protruded from the base; and a fixing member being inserted from one side to the other side of the heat dissipation member to fix the switching element and the heat dissipation member to each other, wherein the fixing member has a clip shape that presses the switching element toward the heat dissipation member.

An insulation layer may be disposed between the switching element and the heat dissipation member, and an insulation member being disposed on the other side of the heat dissipation member may be included.

The base of the heat dissipation member includes a first step and a second step being protruded outward, and the insulation layer can be disposed between the first step and the second step.

The fixing member includes a first region in which a first hole is formed, the heat dissipation member has a second hole formed at a position corresponding to the first hole of the fixing member, and a screw penetrating the first hole and the second hole may be disposed.

The heat dissipation member may include two protruded portions being protruded in one direction from the first surface on which the first region of the fixing member is disposed, and a groove being formed between the two protruded portions.

The first region of the fixing member may include a first portion having a first length, a second portion having a second length smaller than the first length, and a catching part being in contact with one surface of the two protruded portions between the first portion and the second portion.

The second length of the second portion may be formed to correspond to the groove of the heat dissipation member.

The fixing member may include a first region in which a first hole is formed, a second region being extended from the first region in a direction toward the heat dissipation fin, a third region being extended from the second region and being bent, a fourth region being extended from the first region and being bent in a direction toward the base, a fifth region being extended from the fourth region, and a sixth region being extended from the fifth region.

At least a portion of the fifth region and the sixth region of the fixing member may be in contact with the switching element.

The second region of the fixing member may include a hole shape.

### [Advantageous Effects]

According to the present embodiments, the switching element can be stably fixed on the substrate and heat dissipation can be enhanced. Furthermore, the structure in which it is inserted and fixed from one direction can ensure ease of assembly.

### [Brief Description of Drawings]

FIG. 1 is a perspective view of a fixing assembly according to the present embodiment.
FIG. 2 is an exploded perspective view of a fixing assembly according to the present embodiment.
FIG. 3 is a perspective view of a heat dissipation member and fixing member of a fixing assembly according to the present embodiment.
FIG. 4 is a top view of a fixing assembly according to the present embodiment.
FIG. 5 is a side view of a fixing assembly according to the present embodiment.

### [BEST MODE]

Hereinafter, preferred embodiments of the present invention will be described in detail with reference to the accompanying drawings.

However, the technical idea of the present invention is not limited to some embodiments to be described, but may be implemented in various forms, and inside the scope of the technical idea of the present invention, one or more of the constituent elements may be selectively combined or substituted between embodiments.

In addition, the terms (including technical and scientific terms) used in the embodiments of the present invention, unless explicitly defined and described, can be interpreted as a meaning that can be generally understood by a person skilled in the art, and commonly used terms such as terms defined in the dictionary may be interpreted in consideration of the meaning of the context of the related technology.

In addition, terms used in the present specification are for describing embodiments and are not intended to limit the present invention. In the present specification, the singular form may include the plural form unless specifically stated in the phrase, and when described as "at least one (or more than one) of A and B and C", it may include one or more of all combinations that can be combined with A, B, and C.

In addition, in describing the components of the embodiment of the present invention, terms such as first, second, A, B, (a), and (b) may be used.

These terms are merely intended to distinguish the components from other components, and the terms do not limit the nature, order or sequence of the components.

And, when a component is described as being 'connected', 'coupled' or 'interconnected' to another component, the component is not only directly connected, coupled or interconnected to the other component, but may also include cases of being 'connected', 'coupled', or 'interconnected' due that another component between that other components.

In addition, when described as being formed or disposed in "on (above)" or "below (under)" of each component, "on (above)" or "below (under)" means that it includes not only the case where the two components are directly in contact with, but also the case where one or more other components are formed or disposed between the two components. In addition, when expressed as "on (above)" or "below (under)", the meaning of not only an upward direction but also a downward direction with respect to one component may be included.

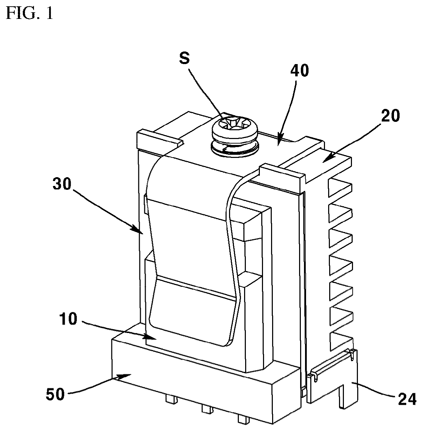

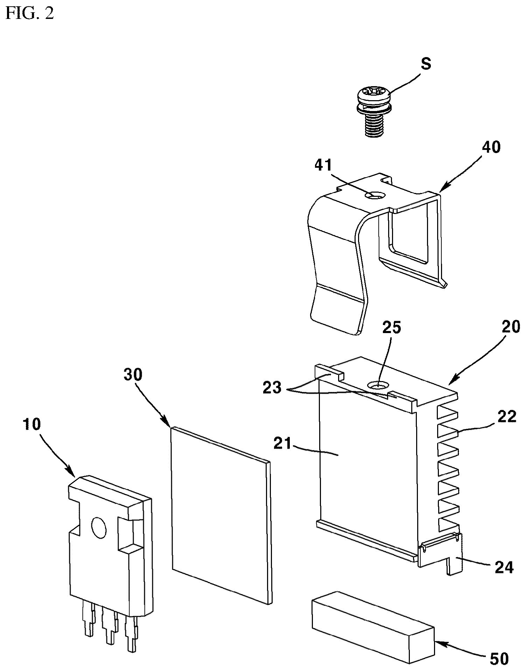

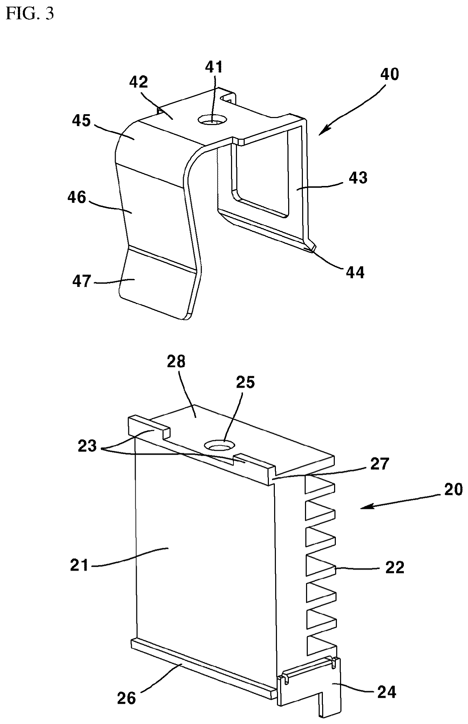

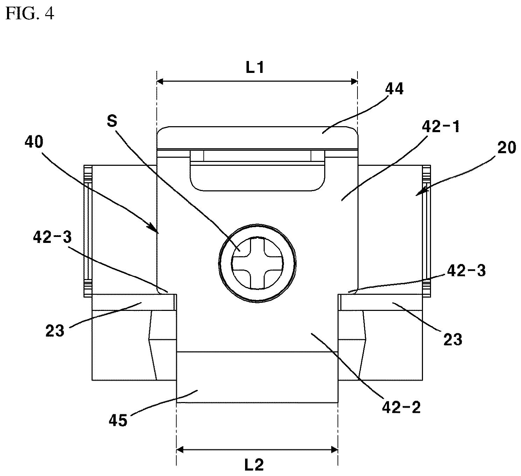

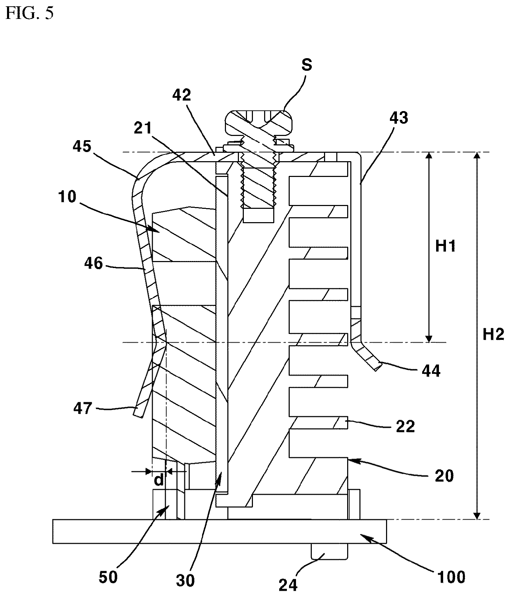

FIG. 1 is a perspective view of a fixing assembly according to the present embodiment; FIG. 2 is an exploded perspective view of a fixing assembly according to the present embodiment; FIG. 3 is a perspective view of a heat dissipation member and fixing member of a fixing assembly according to the present embodiment; FIG. 4 is a top view of a fixing assembly according to the present embodiment; and FIG. 5 is a side view of a fixing assembly according to the present embodiment.

The fixing assembly according to the present embodiment may include a heat dissipation member **20** and a fixing member **40,** and may include an insulation layer **30** and an insulation member **50.** The fixing assembly may be referred to as a bracket.

The heat dissipation member **20** may include a base **21** on one surface of which a switching element **10** is disposed. An insulation layer **30** may be disposed on one surface of the base **21.** A switching element **10** may be disposed on one surface of the base **21.** An insulation layer **30** may be disposed between the base **21** and the switching element **10.** The insulation layer **30** may be formed in a sheet shape.

A plurality of heat dissipation fins **22** may be formed to be protruded from the other surface of the heat dissipation member **20.** The heat dissipation member **20** may include a plurality of heat dissipation fins **22** being protruded from the base **21.** The heat dissipation fin **22** may include a plurality of heat dissipation fins **22** being spaced apart from each other. The plurality of heat dissipation fins **22** may be formed in parallel to each other. A recessed portion may be formed between the plurality of heat dissipation fins **22.** As the contact area with air increases through the plurality of heat dissipation fins **22,** heat being generated from the switching element **10** can be dissipated. The heat dissipation member **20** may be referred to as a heat sink.

Steps may be formed on one side and the other side of the base **21.** The base **21** may include a first step **26** and a second step **27** being protruded outward. An insulation layer **30** may be disposed between the first step **26** and the second step **27.** The position of the insulation layer **30** may be supported through the steps formed on the base **21.** The insulation layer **30** may be disposed between the switching element **10** and the heat dissipation member **20** to perform an insulating function. The insulation layer **30** may be made of a ceramic material. The insulation layer **30** may be referred to as an insulating plate.

The heat dissipation member **20** may include a first surface on which a first region **42** of the fixing member **40** is disposed. A hole **25** may be formed on an upper surface of the heat dissipation member **20.** A screw **S** may be inserted into the hole **25** and coupled. The hole **25** of the heat dissipation member **20** may correspond to the hole **41** of the fixing member **40.** The hole **25** of the heat dissipation member **20** and the hole **41** of the fixing member **40** are disposed to be overlapped with each other, and the screw **S** may be coupled by penetrating each hole. The hole **25** of the heat dissipation member **20** may be referred to as a first hole, and the hole **41** of the fixing member **40** may be referred to as a second hole.

The upper surface of the heat dissipation member **20** may include a protruded portion **23** being protruded upward. The protruded portion **23** may be formed to be protruded upward from both side surfaces. The protruded portion **23** may include two protruded portions **23** being spaced apart from each other. A groove in which a fixing member **40** is disposed may be included between the two protruded portions **23.** The protruded portion **23** may serve as a stopper for the fixing member **40.**

The other side of the heat dissipation member **20** may include a lead **24** being inserted and fixed into the substrate **100.** The lead **24** may be formed to be extended downward by being coupled to a side surface of the heat dissipation member **20.** The lead **24** may be formed in '¬' shape.

The switching element **10** may be an FET element or a diode element. The switching element **10** may include a body and a plurality of pins being extended from the body and connected to the substrate **100.** An insulation member **50** may be disposed on a lower surface of the body of the switching element **10.**

An insulation member **50** may be disposed between the switching element **10** and the substrate **100.** The insulation member **50** may be disposed between the switching element **10** and the substrate **100** to perform an insulating function. The insulation member **50** may be made of a silicone material or a rubber material. The insulation member **50** may be disposed on the other side of the heat dissipation member **20.** The insulation member **50** may be disposed between the substrate **100** and the base **21.** The insulation member **50** may be disposed between the base **21** and the lead **24.** The insulation member **50** may serve to support the base **21** being disposed on the substrate **100.**

The fixing member **40** may be formed in a clip shape. The fixing member **40** may have a clip shape that presses the switching element **10** toward the heat dissipation member **20.** The fixing member **40** may be formed to surround the base **21,** the heat dissipation fin **22,** and the first surface **28** connecting the base **21** and the heat dissipation fin **22** of the heat dissipation member **20.** The fixing member **40** may be inserted from one side of the heat dissipation member **20** toward the other side to fix the switching element **10** and the heat dissipation member **20.**

The fixing member **40** may include a first region **42** in which a hole **41** is formed. The first region **42** may be disposed on an upper surface of the heat dissipation member **20.** The first region **42** of the fixing member **40** may include a first portion **42-1** having a first length **L1,** a second portion **42-2** having a second length **L2** smaller than the first length **L1,** and a catching part **42-3** being in contact with one surface of two protruded portions **23** between the first portion **42-1** and the second portion **42-2.** Through this, the position of the fixing member **40** may be fixed on the heat dissipation member **20.**

The fixing member **40** may include a second region **43** being extended from the first region **42** toward the heat dissipation fin **22,** a third region **44** being extended from the second region **43** and being bent. The fixing member **40** may include a fourth region **45** being extended from the first region **42** toward the base **21** and being bent, a fifth region **46** being extended from the fourth region **45,** and a sixth region **47** being extended from the fifth region **46.** The first region **42** to the sixth region **47** are used to conveniently refer to one fixing member **40,** and the fixing member **40** may include additional regions in addition to the first region **42** to the sixth region **47,** and any one among the first region **42** to the sixth region **47** may be omitted. The second region **43** and the third region **44** of the fixing member **40** may face the heat dissipation fin **22,** and the fourth to sixth regions **45, 46** and **47** may face the switching element **10** or the base **21.**

The second region **43** of the fixing member **40** may be extended in a vertical direction relative to the first region **42.** The second region **43** may include a hole shape. The hole shape of the second region **43** allows the heat dissipation fin **22** to be exposed to the outside, thereby increasing heat dissipation efficiency.

At least a portion of the second region **43** and the third region **44** of the fixing member **40** may be in contact with the heat dissipation fin **22.** The second region **43** and the third region **44** of the fixing member **40** may not be in contact with the heat dissipation fin **22.** The second region **43** and the third region **44** of the fixing member **40** may be formed to have an obtuse angle. This allows the fixing member **40** to serve as a guide when it is inserted while surrounding the outer surface of the heat dissipation member **20,** thereby facilitating assembly.

The fourth region **45** of the fixing member **40** may be formed into a curved surface. The fourth region **45** may be formed into a bent shape. The fifth region **46** of the fixing member **40** may be extended from the fourth region **45** and come into contact with the switching element **10.** The sixth region **47** of the fixing member **40** may be formed to have an obtuse angle with the fifth region **46.** Through this, when the fixing member **40** is inserted while surrounding the outer surface of the heat dissipation member **20,** it may serve as a guide and facilitate assembly.

At least a portion of the fifth region **46** and the sixth region **47** of the fixing member **40** may be in contact with the switching element **10.** The fifth region **46** and the sixth region **47** of the fixing member **40** may have a region **d** being overlapped with the switching element **10.** The fixing member **40** may stably fix the switching element **10** through a seesaw effect via the region **d** being overlapped with the switching element **10.**

Referring to FIG. 5, which illustrates a side view of a fixing assembly according to an embodiment of the present invention, a line connecting the boundary points of the second region **43** and the third region **44** of the fixing member **40** and the boundary points of the fifth region **46** and the sixth region **47** may be formed on an imaginary line. The length **H1** from the first region **42** to the second region **43** of the fixing member **40** may be formed as half the length **H2** from the first region **42** to the substrate **100.** The length **H1** from the first region **42** of the fixing member **40** to the boundary points of the fifth region **46** and the sixth region **47** may be formed as half the length **H2** from the first region **42** to the substrate **100.** Through this, the fixing member can more stably fix the switching element and heat dissipation member.

Those skilled in the art related to the present embodiment will understand that the above-described description can be implemented in a modified form without departing from the essential characteristics thereof. Therefore, the disclosed methods should be considered from an illustrative rather than a restrictive perspective. The scope of the present invention is indicated by the claims, not the above description, and all differences within the scope equivalent thereto should be interpreted as being included in the present invention.

## Claims

1. A fixing assembly comprising:
a heat dissipation member including, on one surface thereof, a base on which a switching element is disposed, and on the other surface thereof, a plurality of heat dissipation fins being protruded from the base; and
a fixing member being inserted from one side to the other side of the heat dissipation member to fix the switching element and the heat dissipation member to each other,
wherein the fixing member has a clip shape that presses the switching element toward the heat dissipation member.

2. The fixing assembly according to claim 1,
wherein an insulation layer is disposed between the switching element and the heat dissipation member, and
wherein an insulation member being disposed on the other side of the heat dissipation member is included.

3. The fixing assembly according to claim 2,
wherein the base of the heat dissipation member includes a first step and a second step being protruded outward, and
wherein the insulation layer is disposed between the first step and the second step.

4. The fixing assembly according to claim 1,
wherein the fixing member includes a first region in which a first hole is formed,
wherein the heat dissipation member has a second hole formed at a position corresponding to the first hole of the fixing member, and
wherein a screw penetrating the first hole and the second hole is disposed.

5. The fixing assembly according to claim 4,
wherein the heat dissipation member includes two protruded portions being protruded in one direction from the first surface on which the first region of the fixing member is disposed, and a groove being formed between the two protruded portions.

6. The fixing assembly according to claim 5,
wherein the first region of the fixing member includes a first portion having a first length, a second portion having a second length smaller than the first length, and a catching part being in contact with one surface of the two protruded portions between the first portion and the second portion.

7. The fixing assembly according to claim 6,
wherein the second length of the second portion is formed to correspond to the groove of the heat dissipation member.

8. The fixing assembly according to claim 1,
wherein the fixing member includes a first region in which a first hole is formed, a second region being extended from the first region in a direction toward the heat dissipation fin, a third region being extended from the second region and being bent, a fourth region being extended from the first region and being bent in a direction toward the base, a fifth region being extended from the fourth region, and a sixth region being extended from the fifth region.

9. The fixing assembly according to claim 8,
wherein at least a portion of the fifth region and the sixth region of the fixing member is in contact with the switching element.

10. The fixing assembly according to claim 8,
wherein the second region of the fixing member includes a hole shape.
